# EUROPEAN PATENT APPLICATION

(11) **EP 4 756 872 A1**
(43) Date of publication of application: **10.06.2026**
(21) Application number: 24857903.9
(22) Date of filing: 31.05.2024
(51) Int. Cl.: H01L 23/31

(54) **SEMICONDUCTOR PACKAGING STRUCTURE AND PACKAGING METHOD THEREOF, AND ELECTRONIC DEVICE**

(30) Priority: 01.09.2023 CN 202311138713
(71) Applicant: HUAWEI TECHNOLOGIES CO., LTD., Shenzhen, Guangdong 518129 (CN)
(72) Inventor: MA, Huilin, Shenzhen, Guangdong 518129 (CN); ZHANG, Shiwei, Shenzhen, Guangdong 518129 (CN); JING, Weiliang, Shenzhen, Guangdong 518129 (CN); LIU, Shuguang, Shenzhen, Guangdong 518129 (CN)
(74) Representative: MERH-IP Matias Erny Reichl Hoffmann Patentanwälte PartG mbB
(86) International application number: PCT/CN2024/096771
(87) International publication number: WO 2025/044358

(57) **Abstract**

This application relates to the field of electronic technologies, and provides a semiconductor package structure and a packaging method thereof, and an electronic device, to resolve a defect in stacked semiconductor packaging. The semiconductor package structure includes: a substrate, and a first chip and a second chip that are stacked on the substrate, where the first chip is located between the substrate and the second chip; a filling part, surrounding a side face of the first chip and a side face of the second chip, and being continuous in a direction perpendicular to the substrate; and a support ring, where an orthographic projection of the support ring on the substrate surrounds an orthographic projection of the first chip on the substrate, the support ring is embedded in the filling part, and is located on a side that is of a first reference plane and that is close to the substrate, and the first reference plane is a plane on which a surface that is of the second chip and that is close to the first chip is located. The semiconductor package structure may be used in an electronic device.

## Description

This application claims priority to Chinese Patent Application No. 202311138713.X, filed with the China National Intellectual Property Administration on September 1, 2023 and entitled "SEMICONDUCTOR PACKAGE STRUCTURE AND PACKAGING METHOD THEREOF, AND ELECTRONIC DEVICE", which is incorporated herein by reference in its entirety.

### TECHNICAL FIELD

This application relates to the field of electronic technologies, and in particular, to a semiconductor package structure and a packaging method thereof, and an electronic device.

### BACKGROUND

With rapid development of science and technology, people have increasingly high requirements for functions of high-tech electronic products, such as a personal computer, a mobile phone, and a smartwatch. Performance of a semiconductor device is one of key factors that determine a function of an electronic product. The semiconductor device is usually manufactured in the following manner: sequentially depositing a dielectric layer, a conductive layer, and a semiconductor material layer on a semiconductor base, and patterning each material layer by using a process such as photolithography or etching to form a circuit component or a circuit element. Usually, a plurality of integrated circuits are formed on the semiconductor base. To protect and facilitate use of the integrated circuits, it is usually necessary to package the integrated circuits.

Generally, packaging includes dicing the semiconductor base from a front-end process into a small die (die) by using a dicing process, attaching a diced die to a corresponding island on a substrate (lead frame) by adhesive, and connecting a bond pad (bond pad) of the dice to a corresponding lead (lead) of the substrate by using an ultra-fine metal (gold, tin, copper, or aluminum) wire or conductive resin, to form a required circuit. Then, the individual die is packaged and protected with a plastic shell.

As a size of the circuit component or the circuit element approaches a physical limit, it is difficult to further reduce the size of the circuit component and the circuit element. In this case, people turn attention to how to well package integrated circuits with various functions together to improve performance of the semiconductor device and reduce a size of the semiconductor device. As a result, various advanced packaging technologies emerge continuously. Stacked packaging has obtained a place in advanced packaging due to a small size and low energy consumption. However, stacked packaging in a conventional technology also has some problems, for example, voids are likely to be formed when a plastic packaging material is filled between stacked chips. The voids may affect reliability of a packaged semiconductor device, and also cause cracks during dicing. Therefore, a stacked package structure and a stacked packaging method need to be improved.

### SUMMARY

Embodiments of this application provide a semiconductor package structure and a packaging method thereof, and an electronic device, to resolve a problem that voids are likely to be formed in a semiconductor package structure and stability of a semiconductor device is affected.

To achieve the foregoing objectives, the following technical solutions are used in embodiments.

According to a first aspect, a semiconductor package structure is provided, including: a substrate, and a first chip and a second chip that are stacked on the substrate, where the first chip is located between the substrate and the second chip; a filling part, surrounding a side face of the first chip and a side face of the second chip, and being continuous in a direction perpendicular to the substrate; and a support ring, where an orthographic projection of the support ring on the substrate surrounds an orthographic projection of the first chip on the substrate, the support ring is embedded in the filling part, and is located on a side that is of a first reference plane and that is close to the substrate, and the first reference plane is a plane on which a surface that is of the second chip and that is close to the first chip is located.

According to the semiconductor package structure provided in this embodiment of this application, the first chip and the second chip are stacked on the substrate. This can reduce a package size, and help implement lightness and thinning of an electronic device. In addition, the support ring is embedded in the filling part, the orthographic projection of the support ring on the substrate surrounds the orthographic projection of the first chip on the substrate, and the support ring is located on the side that is of the first reference plane and that is close to the substrate. The first reference plane is the plane on which the surface that is of the second chip and that is close to the first chip is located. In this way, the support ring is disposed in a region that is prone to a bowl-shaped defect, which enhances wear resistance of the region and can alleviate or avoid the bowl-shaped defect. Filling above the region does not cause a void defect inside the filling part, thereby improving stability of the semiconductor package structure. This improves the technical problems to be resolved.

In a possible implementation of the first aspect, the support ring is located between the first reference plane and a second reference plane, and the second reference plane is a plane on which a surface that is of the first chip and that is close to the second chip is located. In this way, a position of the support ring is defined, so that the support ring and a redistribution layer can be disposed at a same height, and further the support ring and the redistribution layer can be disposed at a same layer. This simplifies a process.

In a possible implementation of the first aspect, a redistribution layer is disposed on a surface that is of the first chip and that is away from the substrate, and the redistribution layer includes a dielectric layer. The filling part includes a first filling layer. The first filling layer surrounds at least a portion of a region between the first chip and the second chip, a material of the first filling layer is the same as a material of the dielectric layer, and the support ring is embedded in the first filling layer. In this implementation, the first filling layer and the dielectric layer are made of a same material, and may be implemented by using a same process, which reduces a process flow.

In a possible implementation of the first aspect, the first filling layer and the dielectric layer are disposed at a same layer. In this way, the first filling layer and the dielectric layer may be implemented by using a same process, which reduces process steps.

In a possible implementation of the first aspect, the redistribution layer further includes a plurality of wiring layers. The plurality of wiring layers are stacked in the direction perpendicular to the substrate, the wiring layers are embedded in the dielectric layer, and a material of the support ring is the same as a material of the wiring layer. In this implementation, the support ring and the wiring layer may be disposed by using a same process, which simplifies the process.

In a possible implementation of the first aspect, the support ring and at least one wiring layer that is farthest away from the substrate are disposed at a same layer. This can avoid a defect caused by a lack of support from the support ring when a final wiring layer is formed.

In a possible implementation of the first aspect, a surface that is of the support ring and that is away from the substrate is flush with a surface that is of a wiring layer farthest away from the substrate and that is away from the substrate. In this implementation, a height of the support ring is limited, to avoid worsening the defect when the support ring is lower than the surface of the wiring layer when the final wiring layer is formed.

In a possible implementation of the first aspect, the support ring runs through the first filling layer in the direction perpendicular to the substrate. In this way, the support ring may be disposed in a process of forming the entire redistribution layer, to avoid forming the defect.

In a possible implementation of the first aspect, the filling part further includes a first filling part. The first filling part is located between the first filling layer and the substrate, the first filling part surrounds the side face of the first chip, and the material of the first filling layer is different from a material of the first filling part. In this way, a property of the first filling layer may be different from that of the first filling part, to prevent stress from being accumulated in the filling part.

In a possible implementation of the first aspect, the filling part further includes a second filling part disposed on a side that is of the first filling layer and that is away from the substrate. The second filling part surrounds the side face of the second chip, and the material of the first filling layer is different from a material of the second filling part.

In a possible implementation of the first aspect, there are a plurality of support rings that are radially arranged from inside to outside in a direction parallel to the substrate. In this way, the plurality of support rings are disposed, which can increase uniformity of wear resistance of a region, and further avoids the bowl-shaped defect.

In a possible implementation of the first aspect, among adjacently disposed support rings, a width of a support ring located on an inner side is greater than a width of a support ring located on an outer side, and the width is a size in the direction parallel to the substrate. In this way, a support ring with a larger size is disposed at a place with a large depression to reduce the depression and avoid the defect.

According to a second aspect, a packaging method of a semiconductor package structure is provided, including: attaching a first chip to a substrate; performing filling around the first chip by using a filling material to form a first filling part that surrounds a side face of the first chip; forming, on a surface that is of the first chip and that is away from the substrate, a redistribution layer, a first filling layer surrounding the redistribution layer, and a support ring located in the first filling layer, where the first filling layer is in contact with the first filling part, and an orthographic projection of the support ring on the substrate surrounds an orthographic projection of the first chip on the substrate; attaching a second chip to the redistribution layer; and performing filling around a side face of the second chip by using a filling material, to form a second filling part surrounding the second chip, where the second filling part is in contact with the first filling layer. In a technology known to the inventor of this application, no support ring surrounding the first chip is disposed. When the first chip and the second chip are stacked, because misalignment occurs during alignment of the first chip and the second chip, aspect ratios of gaps around the first chip are inconsistent, and a void defect is caused when filling is performed around the first chip and the second chip. In another technology known to the inventor of this application, after the first chip is stacked on the substrate, filling is performed around the first chip, and the redistribution layer is formed on an upper surface of the first chip. Then, the second chip is stacked on the redistribution layer, and filling is performed around the second chip. Because a bowl-shaped defect exists on the redistribution layer, a void is also formed after filling is performed around the second chip. Existence of the void affects stability of the semiconductor package structure, and during dicing for singulation, cracks may be caused and extend to the inside of the chip, which damages the chip.

According to the packaging method of the semiconductor package structure provided in this embodiment, because the support ring is disposed on a layer that is the same as a wiring layer of the redistribution layer, the support ring surrounds the first chip to provide support for a region in which the bowl-shaped defect is caused, which enhances wear resistance of the region and can alleviate or avoid the bowl-shaped defect. Therefore, when filling is performed around the second chip, voids are accordingly alleviated or avoided, and stability of the semiconductor package structure is improved.

In a possible implementation of the second aspect, the redistribution layer includes a dielectric layer and a wiring layer, and the first filling layer and the dielectric layer are simultaneously formed. In this way, the first filling layer and the dielectric layer are simultaneously formed, which can reduce a process.

In a possible implementation of the second aspect, the support ring and at least a portion of the wiring layer are simultaneously formed. In this way, the support ring and the wiring layer are simultaneously formed, so that a process can be reduced, and the support ring may be located at a position that is prone to the bowl-shaped defect, to avoid the defect.

According to a third aspect, an electronic device is provided, including the semiconductor package structure according to any implementation of the first aspect and a printed circuit board. The semiconductor package structure is attached to the printed circuit board.

According to the electronic device provided in this embodiment, by using the semiconductor package structure in the foregoing technical solution, lightness and thinning of the electronic device are implemented, and performance of the electronic device is improved.

### BRIEF DESCRIPTION OF DRAWINGS

FIG. 1A is a diagram of a structure of stacking a first chip on a substrate according to an embodiment of this application;
FIG. 1B is a diagram of a structure that is of stacking a second chip on a first chip and that is known to the inventor of this application;
FIG. 1C is a diagram of a structure in which a void is formed after a stacked chip package is filled and that is known to the inventor of this application;
FIG. 1D is a diagram of a stacked chip package structure in an ideal state;
FIG. 2A to FIG. 2F are diagrams of a preparation process of another stacked package structure known to the inventor of this application;
FIG. 3 is a diagram of a three-dimensional structure of a semiconductor package structure according to an embodiment of this application;
FIG. 4 is a cross-sectional view in an A-A' direction in FIG. 3;
FIG. 5 is a partially enlarged view of a portion in a dashed-line box P2 in FIG. 4;
FIG. 6A to FIG. 6I are diagrams of a preparation process of forming a structure such as a redistribution layer in a semiconductor package structure according to an embodiment of this application;
FIG. 7A is a sectional view in a B-B' direction in FIG. 3;
FIG. 7B is another sectional view in a B-B' direction in FIG. 3;
FIG. 8A to FIG. 8C are diagrams of a preparation process in which a second chip is stacked on a first chip to form a semiconductor package structure according to an embodiment of this application;
FIG. 9 is a flowchart of a packaging method of a semiconductor package structure according to an embodiment of this application; and
FIG. 10 is a diagram of a structure of an electronic device according to an embodiment of this application.

### DESCRIPTION OF EMBODIMENTS

Technical terms or scientific terms used in this application should have general meanings understood by a person skilled in the art, unless otherwise defined. In the specification and claims of this application, the terms "first", "second", "third", and the like are not intended to indicate any order, quantity, or significance, but are intended to distinguish between different components. Therefore, a feature limited by "first", "second", or "third" may explicitly or implicitly include one or more features. In the descriptions of embodiments of this application, unless otherwise specified, "a plurality of" means two or more than two.

Orientation terms such as "left", "right", "up", and "down" are defined with respect to an orientation in which a device is schematically placed in a drawing. It should be understood that these directional terms are relative concepts and are used for relative description and clarification, which can be changed accordingly based on a change of an orientation in which a chip or a semiconductor package structure is placed.

With development of technologies, people have increasingly high requirements for functions of an electronic device, for example, higher portability of the electronic device, which requires reducing a size of the device and improving an integration level of the device, and for another example, a faster response speed and a reduced delay of the electronic device. Increasing a quantity of transistors integrated in a chip is one of methods to meet the requirements. However, based on a development trend of an existing storage chip, a size of a transistor in the chip has approached a physical limit, and a speed of improving performance of a single chip by reducing the size of the transistor is slowed down. Therefore, to reduce the size of the electronic device and improve performance of the electronic device, a skilled person shifts from conventional chip packaging to a packaging form of multi-layer chip stacking.

Multi-layer chip stacking includes substrate-to-substrate (wafer to wafer) stacking, chip-to-substrate (die to wafer) stacking, and chip-to-chip (die to die) stacking. Substrate-to-substrate stacking has a highest efficiency. However, a warping of a substrate may affect bonding precision of metal pads on two substrates. In addition, there is a chip that does not meet a requirement on the substrate, and the chip is also bonded with a chip on another substrate, which reduces a product yield. In chip-to-substrate stacking, a known good chip (known good die) is selected for stacking. This may avoid that an unqualified chip is used for packaging, balancing both the product yield and a production yield. Therefore, chip-to-substrate stacking is a good tradeoff.

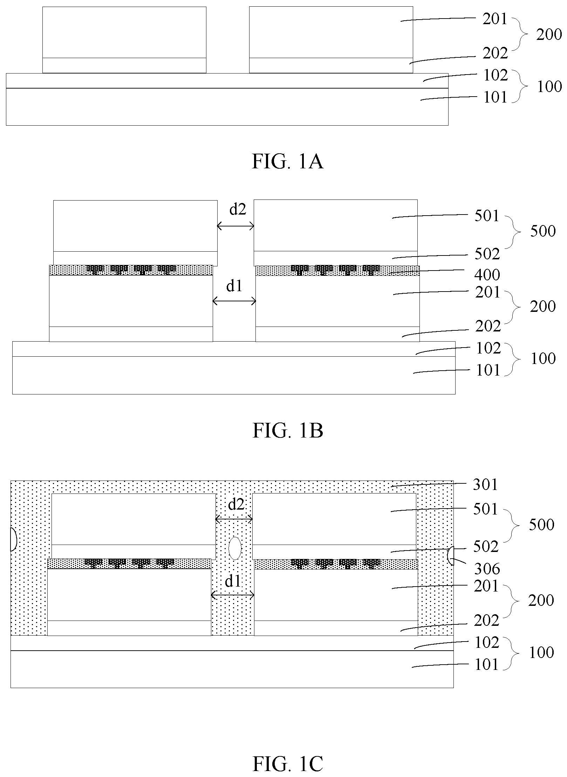

With reference to FIG. 1A to FIG. 1C, the following describes a process of a chip stacking process and a possible problem thereof that are known to the inventor.

FIG. 1A is a diagram of a structure of stacking a first chip 200 on a substrate 100 in a chip-to-substrate stacking process. The substrate 100 includes a substrate body 101 and a substrate interconnection layer 102, and the first chip 200 includes a first chip body 201 and a first interconnection layer 202. The substrate 100 is stacked by attaching the substrate interconnection layer 102 to the first interconnection layer 202 of the first chip 200.

In some implementations, the substrate body 101 and the first chip body 201 may be made of silicon, or may be made of a group-III element, a group-IV element, and/or a group-V element (for example, silicon, germanium, gallium, arsenic, and a combination thereof). The substrate body 101 may alternatively be in a silicon-on-insulator (silicon-on-insulator, SOI) form. The silicon-on-insulator substrate body may include a layer that is of a semiconductor material (for example, silicon, germanium, and/or the like) and that is formed on an insulator layer (for example, buried oxide (buried oxide) and/or the like). The insulator layer is formed on the silicon substrate body. The substrate body 101 includes a circuit element (not shown in the figure) by using a semiconductor process step such as doping, photolithography, etching, deposition, or the like. In some implementations, various circuit elements may include various n-type metal oxide semiconductor (n-type metal-oxide semiconductor, NMOS) apparatuses and/or p-type metal oxide semiconductor (p-type metal-oxide semiconductor, PMOS) apparatuses such as a transistor, a capacitor, a resistor, a diode, a photodiode, a fuse, and/or the like. The circuit elements on the substrate body 101 are divided into a plurality of regions, and circuit elements in each region are connected through a conductive wire in the substrate interconnection layer 102, to implement a specific function, such as a logical operation and data storage. In addition, when a final product is formed, the substrate body 101 is diced, and the final product includes only one of the regions or some of the regions. When there are a plurality of regions, functions of the plurality of regions may be the same or may be different. A difference between the first chip body 201 and the substrate body 101 lies only in that the first chip body 201 does not need to be diced when the final product is formed. However, a circuit element on the first chip body 201 may be one or more regions. Similarly, when there are a plurality of regions, functions of the plurality of regions may be the same or may be different.

In some implementations, for the substrate interconnection layer 102 and the first interconnection layer 202, an insulating dielectric layer may be deposited on the substrate body 101 and the first chip body 201. A wiring layer (not shown in the figure) may be formed on the insulating dielectric layer by using a semiconductor process step such as photolithography, development, etching, sputtering, chemical mechanical polishing (chemical mechanical polishing, CMP), or the like. The wiring layer may include a conductive wire and a bonding contact. The insulating dielectric layer may be made of a low-k dielectric material (low-k dielectric material), and the conductive wire and the bonding contact may be made of a metal material such as copper, tungsten, tin, or the like. In some implementations, the conductive wire and the bonding contact may further include a seed layer and a barrier layer (not shown in the figure). The seed layer is formed at a preset position, and then a conductive material for the conductive wire and the bonding contact is deposited on the thin seed layer. The seed layer may include copper, titanium, nickel, gold, manganese, a similar material, or a combination thereof, and may be formed by using ALD, PVD, a similar process, or a combination thereof.

The circuit elements on the substrate body 101 and the first chip body 201 are connected to each other through the substrate interconnection layer 102 and the first interconnection layer 202 at an upper layer to form an integrated circuit for implementing a specific function, and are connected to another circuit through the bonding contact, for example, connected to another chip or another printed circuit board. The integrated circuit herein may be a logic integrated circuit, a memory integrated circuit, a sensor integrated circuit, an analog integrated circuit, or the like.

In some implementations, before the first chip 200 is stacked on the substrate 100, the first chip 200 needs to be picked (pick) from a dicing tape and placed (place) on the substrate 100. The first chip 200 may be attached to the substrate 100 by using a bonding process, and the bonding process may be eutectic bonding, metal thermocompression bonding, hybrid bonding, or the like.

FIG. 1B is a diagram of a structure of stacking a second chip 500 on the first chip 200 according to a related technology known to the inventor of this application. An example in which two layers of chips are stacked on the substrate 100 for packaging is used for description. In some implementations, there are a plurality of first chips 200 that are evenly distributed on a surface of the substrate and are bonded with the substrate 100. After the first chips 200 are bonded with the substrate 100, the second chip 500 is stacked on the first chips 200. In other words, the second chip 500 is bonded with the first chips 200. A structure of the second chip 500 is similar to a structure of the first chip 200. Details are not described herein again.

In some implementations, before the second chip 500 is bonded with the first chips 200, a redistribution layer 400 is pre-formed on an upper surface of the first chip 200. A connection channel that runs through the first chip body 201 is disposed in the redistribution layer 400. A conductive wire is provided in the connection channel, and the redistribution layer is electrically connected to the first chip 200 or the substrate 100 through the conductive wire. Due to a factor such as placement precision of the second chip 500 or warping of the substrate, an error may occur in alignment between the second chip 500 and the redistribution layer 400 on the first chip 200. For example, a left second chip 500 deviates rightward, and a right second chip 500 deviates leftward. In this case, if some second chips 500 other than the two second chips 500 implement precise alignment, a left gap and a right gap of the left second chip 500 may be inconsistent. The left gap is a distance between the left second chip 500 and an adjacent left second chip 500, and the right gap is a distance between the left second chip 500 and an adjacent right second chip 500. As a result, aspect ratios (aspect ratio) of gaps around the second chips 500 are inconsistent. In addition, in a same gap, due to misalignment of the second chips 500, a width d1 of a gap between the first chips 200 is greater than a width d2 of a gap between the second chips 500.

Refer to FIG. 1C. After the second chip 500 is bonded with the first chip 200, a filling material 301 is used to fill around the first chip 200 and the second chip 500. In some embodiments, the filling material may include, for example, a molding compound such as epoxy resin, resin, moldable polymer, or polyimide, and a silicon compound such as silicon oxide, silicon nitride, silicon oxynitride, or a silicon-glass bonded compound. The width d1 of the gap between the first chips 200 is different from the width d2 of the gap between the second chips 500, and the aspect ratios of gaps around the second chips 500 are inconsistent. If a filling material of a same property is used for filling, a defect may be caused after filling. For example, after the filling material is cured, a void 306 may be formed inside the filling material, and existence of the void 306 may affect stability of the chips. To avoid this problem, it is required that a filling material for filling the gap between the first chips 200 and a filling material for filling the gap between the second chips 500 have a specific difference, for example, a difference in fluidity or a difference in a volume change after curing. First, it is difficult to implement precise control on the difference between the filling materials. Second, because a position of the second chip 500 after bonding is uncertain, it is difficult to select a property of the filling material based on a specific gap.

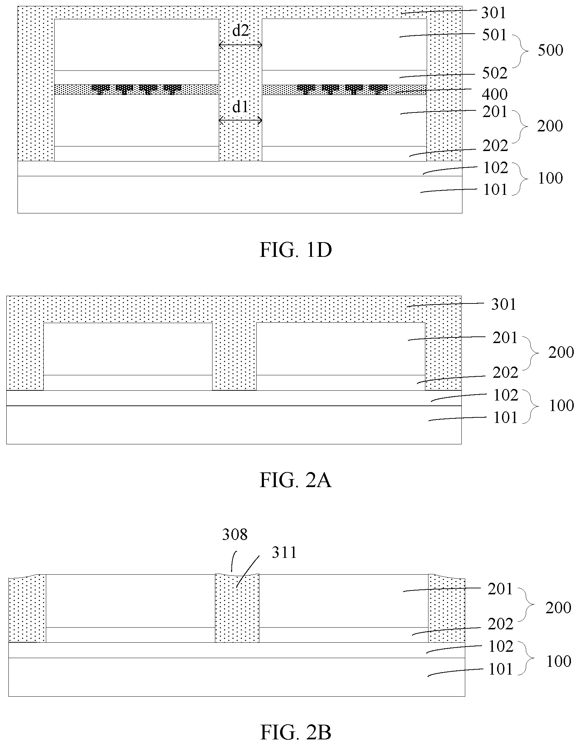

FIG. 1D is a diagram of a structure in which chips are stacked in an ideal state. The first chip 200 and the second chip 500 are not misaligned during bonding, and there is no void defect in the filling material 301 around the first chip 200 and the second chip 500.

To alleviate a problem caused by the foregoing stacking methods and achieve an ideal apparatus, the following technical solution is provided.

FIG. 2A to FIG. 2F are diagrams of a preparation process of a stacked package structure known to the inventor of this application.

Refer to FIG. 2A. In some implementations, after the first chip 200 is bonded with the substrate 100, the filling material 301 is used to fill around the first chip 200. In a specific implementation, a plurality of first chips 200 are simultaneously bonded with the substrate 100, the plurality of first chips 200 are arranged on a plane in which a surface of the substrate 100 is located, and the filling material 301 fills the gap between the first chips 200. The filling material may include a molding compound such as epoxy resin, resin, moldable polymer, polyimide, or the like. A dicing street (dicing street) that forms a separate package body through singulation may be disposed in the gap between the first chips 200. To ensure a filling effect, a height of the filling material 301 after filling is higher than an upper surface of the first chip 200. Therefore, to further stack a chip on the upper surface of the first chip 200, planarization processing needs to be performed on the upper surface of the first chip 200 and an upper surface of the filling material 301.

Refer to FIG. 2B. After the filling material 301 is used to fill around the first chip 200, planarization processing is performed the upper surfaces of the first chip 200 and the filling material 301. Planarization processing may be performed by using chemical mechanical polishing (chemical mechanical polish, CMP), etching, or another suitable process. After planarization processing, it is expected that the upper surface of the filling material 301 is substantially coplanar with the upper surface of the first chip 200 within a process change, and the filling material 301 that surrounds the first chip 200 forms a first filling part 311. However, due to a difference between a material of the first chip 200 and the filling material 301, a bowl-shaped depression (dishing) 308 may be formed on an upper surface of the first filling part 311 after planarization. For example, when the chemical mechanical polishing process is used for planarization, to reduce a loss caused by the process to the first chip 200, wear resistance of the filling material 301 is inferior to wear resistance of the first chip 200. As a result, the filling material 301 is polished faster than the first chip 200, and therefore the bowl-shaped depression is formed on the upper surface of the first filling part 311.

After planarization processing, to implement chip stacking, that is, to attach the second chip 500 to the upper surface of the first chip 200, the second chip 500 needs to be electrically connected to the substrate 100 or the first chip 200. In some implementations, a channel (not shown in the figure) that runs through at least the first chip body 201 of the first chip 200 is formed on the first chip 200. By filling a conductive material such as copper, tungsten, or polycrystalline silicon in the channel, the first chip 200 or the substrate 100 may be electrically connected to the second chip 500. The channel may be formed by using a plasma etching process, or may be formed by using another process. It is easy to understand that, if an electrical connection is implemented only by filling the conductive material in the channel, a position of the channel limits a position of a bonding contact of the second chip 500. This is not conducive to stacking.

Therefore, before the second chip 500 is stacked on the first chip 200, the redistribution layer 400 needs to be formed on the upper surface of the first chip 200, and the redistribution layer 400 is configured to change a layout position of a bonding contact that is on the upper surface of the first chip 200 and that is used to electrically connect the first chip 200 and the second chip 500. In some implementations, to meet some specific requirements, another film layer, for example, a film layer for improving insulation, is disposed between the redistribution layer 400 and the first chip 200.

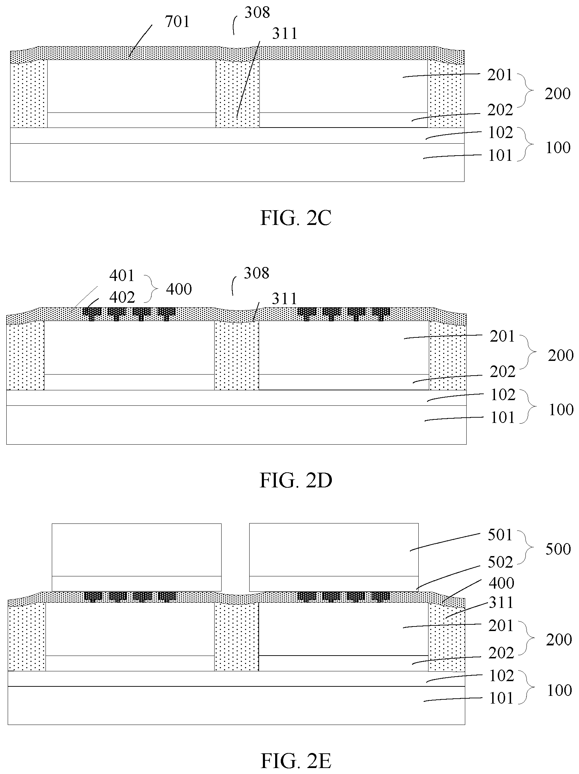

The redistribution layer 400 includes an insulating dielectric layer 401 and a wiring layer 402. Refer to FIG. 2C. A layer of an insulating dielectric material 701 is first deposited on the upper surfaces of the first chip 200 and the first filling part 311 to form the dielectric layer 401 in a subsequent process. The deposited insulating dielectric material 701 may be considered to have an equal thickness. Therefore, a bowl-shaped defect 308 on the upper surface of the first filling part 311 also exists.

Still refer to FIG. 2D. The insulating dielectric layer 401 and the wiring layer 402 are formed by performing processes such as photolithography, etching, sputtering, and planarization on the insulating dielectric material 701, and the wiring layer 402 is embedded in the insulating dielectric layer 401. During processing of a planarization process, because the wiring layer is disposed in the insulating dielectric material 701 in an upper region of the first chip 200, that is, there is a conductive wire, the conductive wire increases wear resistance of the upper region of the first chip 200. However, the insulating dielectric material 701 above the first filling part 311 has no wiring layer, and therefore has lower wear resistance than the upper surface of the first chip 200. As a result, when the planarization process is performed, the bowl-shaped defect 308 of the insulating dielectric material 701 in the upper region of the first filling part is aggravated. For example, an opening of the bowl-shaped defect 308 of the insulating dielectric material 701 is larger than an opening of the bowl-shaped defect 308 of the first filling part 311.

Refer to FIG. 2E. After the redistribution layer 400 is formed, the second chip 500 is attached to the redistribution layer 400, and the attachment may be performed in a same manner as the attachment of the first chip 200 to the substrate 100. The second chip 500 is picked (pick) from the dicing tape and placed (place) on the redistribution layer 400. Due to a factor such as the warping of the substrate or lack of a reliable reference object, an error may also occur in alignment between the bonding contact of the second chip 500 and a bonding contact of the redistribution layer 400, and misalignment may occur.

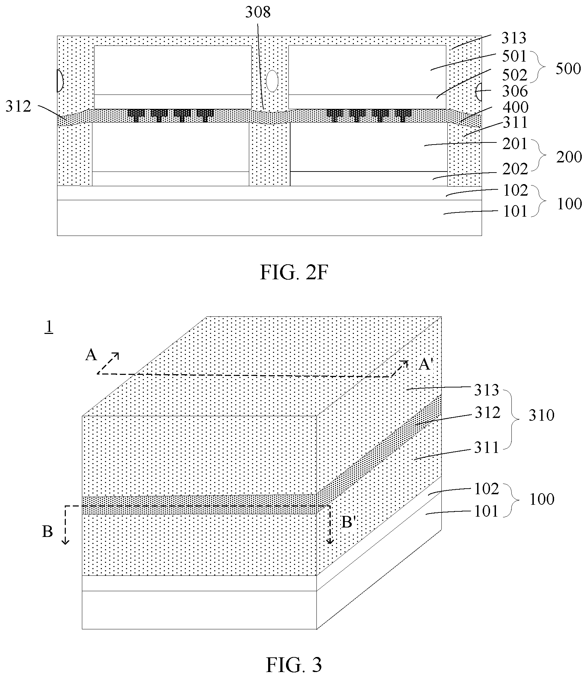

Refer to FIG. 2F. The filling material 301 is used to fill around the second chip 500 to form a second filling part 313. Because the first filling layer 312 has a bowl-shaped defect 308, a void 306 may be formed in the second filling part 313, affecting stability of the semiconductor package structure.

In the stacked packaging method shown in FIG. 2A to FIG. 2F, although misalignment may also occur after the second chip 500 is attached, because the gap around the first chip 200 is first filled, and then the gap around the second chip 500 is filled, a method of filling for a plurality of times may alleviate impact caused by inconsistent aspect ratios of the gaps. It is easy to understand that, in the stacked packaging method shown in FIG. 2A to FIG. 2F, the redistribution layer 400 is formed on the upper surface of the first chip 200 only after the first chip 200 is attached to the substrate 100. However, it should be understood that similar technical effects may also be achieved when the redistribution layer is formed on the upper surface of the first chip 200 before the first chip 200 is attached to the substrate 100. In addition, both the two stacked packaging methods in which the redistribution layer is formed at different time include a planarization process step. To be specific, there is the planarization process step after the gap around the first chip 200 that is already attached to the substrate 100 is filled with the filling material. As described above, the planarization process may cause the bowl-shaped defect 308. After filling, the bowl-shaped defect 308 may cause formation of the void 306 in the filling material, which affects reliability of a device formed after the stacked packaging.

To avoid or alleviate a problem caused by the bowl-shaped defect 308, an embodiment of this application provides a semiconductor package structure. An example in which two layers of chips are stacked on a substrate is used for description. It is easy to understand that, in specific implementation, this application may be extended to that a plurality of layers of chips are stacked on the substrate. FIG. 3 is a diagram of a three-dimensional structure of a semiconductor package structure. The semiconductor package structure 1 includes a substrate 100 and a filling part 310. The filling part includes a first filling part 311, a first filling layer 312, and a second filling part 313. The substrate 100 includes a substrate body 101 and a substrate interconnection layer 102. A first chip 200 and a second chip 500 are disposed in the filling part 310.

Materials and structures of the substrate 100, the first filling part 311, the first filling layer 312, and the second filling part 313 may be consistent with the materials and the structures of the substrate 100, the first filling part 311, the first filling layer 312, and the second filling part 313 recorded in the implementations in FIG. 1A to FIG. 2F. Details are not described herein again.

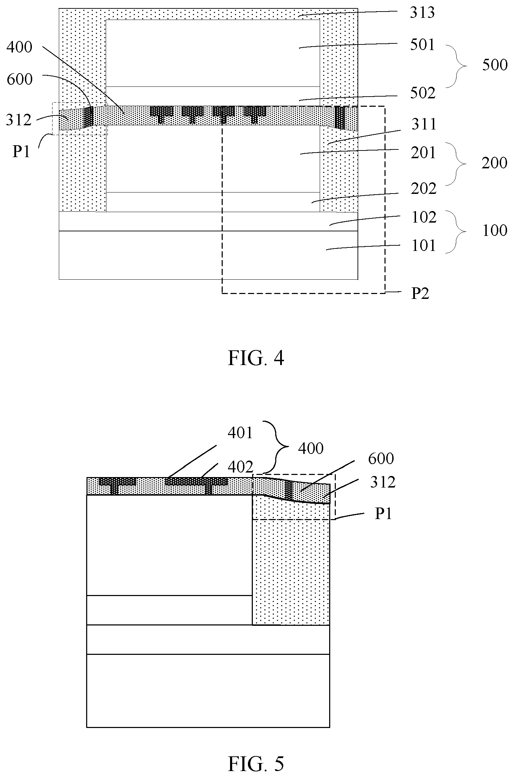

As shown in FIG. 4 (a sectional view in an A-A' direction in FIG. 3), the first chip 200 and the second chip 500 are stacked on the substrate 100, the first chip 200 is located between the substrate 100 and the second chip 500, and a redistribution layer 400 is disposed between the first chip 200 and the second chip 500.

The first chip 200 includes a first interconnection layer 202 and a first chip body 201, and the second chip 500 includes a second interconnection layer 502 and a second chip body 501. In some implementations, the first chip 200 and the second chip 500 are packaged in this embodiment of this application after the first chip 200 and the second chip 500 are manufactured in a wafer factory. In other words, the first chip 200 and the second chip 500 are dies. In some implementations, the first chip 200 and the second chip 500 are packaged before being packaged in this embodiment of this application. The first chip 200 and the second chip 500 may be chips with a same function or may be chips with different functions. In addition, a size relationship between the first chip 200 and the second chip 500 is not limited. For example, a size of the first chip 200 may be the same as a size of the second chip 500 or may be different from a size of the second chip 500.

In some implementations, the first interconnection layer 202 of the first chip 200 and the substrate interconnection layer 102 of the substrate 100 are disposed opposite to each other, and are bonded. A bonding method includes eutectic bonding, metal thermocompression bonding, hybrid bonding, and the like. The second interconnection layer 502 of the second chip 500 is attached to the first chip 200 through the redistribution layer 400.

Refer to FIG. 5. FIG. 5 is a partially enlarged view of a portion in a dashed-line box P2 in FIG. 4. The redistribution layer 400 includes a dielectric layer 401 and a wiring layer 402. The dielectric layer 401 is made of an insulation material, for example, silicon dioxide, to implement electrical isolation. The wiring layer includes a conductive wire and a bonding contact, to implement an electrical connection between the second chip 500 and the first chip 200 or the substrate 100.

The filling part 310 is continuous in a direction perpendicular to the substrate 100, and a support ring 600 is embedded in the filling part 310. The filling part includes the first filling part 311, the first filling layer 312, and the second filling part 313. The first filling layer 312 is the portion in the dashed-line box P1 indicated by a reference mark 312 in FIG. 4, and does not include the support ring 600.

The first filling part 311 surrounds a side face of the first chip 200, and the second filling part 313 surrounds a side face of the second chip 500. A bottom surface of the first filling part 311 is in close contact with an upper surface of the substrate 100, to implement sealing of the first chip 200 and the like. The second filling part 313 and the first filling part 311 are continuous in a direction perpendicular to a surface of the substrate or are continuous through the first filling layer 312. In addition, the second filling part 313 covers the top of the second chip 500 to seal the second chip 500 and the like. In some implementations, the second filling part 313 may surround a portion of a region between the first chip 200 and the second chip 500.

The first filling layer 312 is disposed between the first filling part 311 and the second filling part 313, to implement continuity between the first filling part 311 and the second filling part 313, namely, continuity of the filling part 310. In this case, the support ring 600 is embedded in the first filling layer 312.

In some implementations, the redistribution layer 400 may be formed on the first chip 200 before stacked packaging. For example, the first chip 200 is obtained after front-end manufacturing of the substrate is completed and singulation is performed, a plurality of chips are arranged on a carrier board with a temporary bonding adhesive, a gap between the plurality of chips is filled with a plastic packaging material, and a back surface of the chips is in a plane with the plastic packaging material. Then, the chips are separated from the carrier board, and the redistribution layer 400 is formed on a plane on which the back surface of the chip and the plastic packaging material are located. Finally, the first chip 200 with the redistribution layer 400 is obtained through dicing. Therefore, after the filling material is filled around the first chip 200 and planarization processing is performed, the redistribution layer 400 does not need to be formed. In this case, an upper surface of the first filling part 311 after planarization processing is flush with an upper surface of the redistribution layer 400. This facilitates attachment of the second chip 500 to the first chip 200. In other words, the second filling part 313 is disposed in close contact with the first filling part 311, to implement continuity of the filling part 310. In the implementations, there is no first filling layer 312, and the support ring 600 is embedded in the first filling part 311 or the second filling part 313. In other words, in the implementations, after the first chip 200 and the substrate 100 are bonded and filled to form the first filling part 311, because the redistribution layer 400 is already formed on the first chip 200, there is no need to dispose the redistribution layer 400 on an upper surface jointly formed by the first chip 200 and the first filling part 311. For example, the support ring 600 may be formed on the upper surface of the first filling part 311 by performing a step such as photolithography or deposition.

It may be understood that, in a plurality of cases in which the support ring 600 is embedded in the filling part 310, an orthographic projection of the support ring 600 on the substrate 100 surrounds an orthographic projection of the first chip 200 on the substrate 100. Preferably, the orthographic projection of the support ring 600 on the substrate 100 surrounds the orthographic projection of the first chip 200 on the substrate 100, and the orthographic projection of the support ring 600 on the substrate 100 is spaced apart from the orthographic projection of the first chip 200 on the substrate 100.

If a surface that is of the second chip 500 and that is close to the substrate 100 is used as a first reference plane, the support ring 600 is substantially located on a side that is of the first reference plane and that is close to the substrate 100. The term substantially herein means that impact caused by a process error is not considered. In other words, in an actual product, an upper surface of the support ring 600 may extend beyond the first reference plane by a specific distance, and the distance is caused by the process error.

In some implementations, the redistribution layer 400 may include a plurality of dielectric layers 401 and a plurality of wiring layers 402. In other words, both the dielectric layer 401 and the wiring layer 402 may have a plurality of layers. When the dielectric layer 401 is formed, the first filling layer 312 may be disposed at a same layer. "Disposed at a same layer" means a same process is simultaneously used for disposition. To be specific herein, "disposed at a same layer" means using a same film forming process to form the dielectric layer 401 and the first filling layer 312, using the film forming process to form film layers for specific patterns, and then using a same mask template to simultaneously form the dielectric layer 401 and the first filling layer 312 by using a single patterning process. Based on different structures to be formed, the single patterning process may include a plurality of times of exposure, development, and etching processes, and a structure of the layers formed by disposition at a same layer may be continuous or discontinuous. In some embodiments, more specifically, for the dielectric layer 401 herein, the silicon dioxide is deposited on the upper surface of the first chip 200 by using a deposition process, and in the meantime, the silicon dioxide is also deposited on the upper surface of the first filling part 311 by using the deposition process. After a silicon dioxide film layer is formed through deposition, to form the wiring layer 402 on the dielectric layer 401 and embed the support ring 600 in the first filling layer 312, the silicon dioxide film layer is coated with a photoresist, and the photoresist is exposed by using a same mask. After exposure, a pattern that is not blocked by the photoresist is obtained, and finally the pattern is formed on the silicon dioxide film layer by using an etching process. In this way, the dielectric layer 401 located right above the first chip 200 and the first filling layer 312 located right above the first filling part 311 are formed. In this implementation, the first filling layer 312 and the dielectric layer 401 are continuously disposed. However, it is easy to understand that, in some implementations, the first filling layer 312 and the dielectric layer 401 may not be continuously disposed. In other words, there is a gap between the first filling layer 312 and the dielectric layer 401, and the support ring 600 is embedded in the gap.

In some implementations, a material of the dielectric layer 401 of the redistribution layer 400 is different from a material of the first filling part 311 and a material of the second filling part 313. Because the dielectric layer 401 of the redistribution layer 400 and the first filling layer 312 are disposed at a same layer, the dielectric layer 401 of the redistribution layer 400 and the first filling layer 312 are made of a same material. In addition, a material of the redistribution layer 400 may be different from the filling material 301 for filling a gap during packaging. In other words, the material of the first filling layer 312 is different from the material of the first filling part 311 or the material of the second filling part 313. In some other implementations, the material of the first filling layer 312 may also be the same as the material of the first filling part 311 or the material of the second filling part 313.

In some implementations, the support ring 600 and the wiring layer 402 of the redistribution layer 400 are disposed at a same layer. After the dielectric layer 401 located right above the first chip 200 and the first filling layer 312 located right above the first filling part 311 are formed, a conductive material, for example, copper or tungsten, is disposed by using a process such as sputtering and deposition in the pattern generated by etching, to form the wiring layer 402 and the support ring 600. The wiring layer 402 is embedded in the dielectric layer 401. In this way, the wiring layer 402 and the support ring 600 are made of a same material. In some implementations, the support ring 600 may not be disposed at a same layer as the wiring layer 402. Therefore, the support ring 600 and the wiring layer 402 may be made of different materials, to meet a specific requirement for the support ring 600. To be specific, the conductive material may be first disposed in the pattern generated by etching the dielectric layer 401, and then another material that meets a requirement is disposed in the pattern generated by etching the first filling layer 312.

In some implementations, the support ring 600 is disposed in the first filling layer 312, and the first filling layer 312 is located on a side that is of the first filling part 311 and that is away from the substrate 100. Therefore, the support ring 600 is located on the upper surface of the first filling part 311. When the filling material 301 is filled around the second chip 500, if a surface that is of the first filling layer 312 and that is in contact with the filling material 301 is uneven, the unevenness may affect formation of the second filling part 313 by filling around the second chip 500. This leads to a defect in the second filling part 313 and reduces reliability of the semiconductor package structure 1. Therefore, the support ring 600 is located on a side that is of a plane on which the lower surface of the second chip 500 is located and that is close to the substrate 100.

The following describes, by using an example in which the support ring 600 is disposed in the first filling layer 312, technical effects that the support ring 600 alleviates or avoids the bowl-shaped defect 308, to alleviate or avoid formation of the void 306 in the second filling part, which affects reliability of the semiconductor package structure 1.

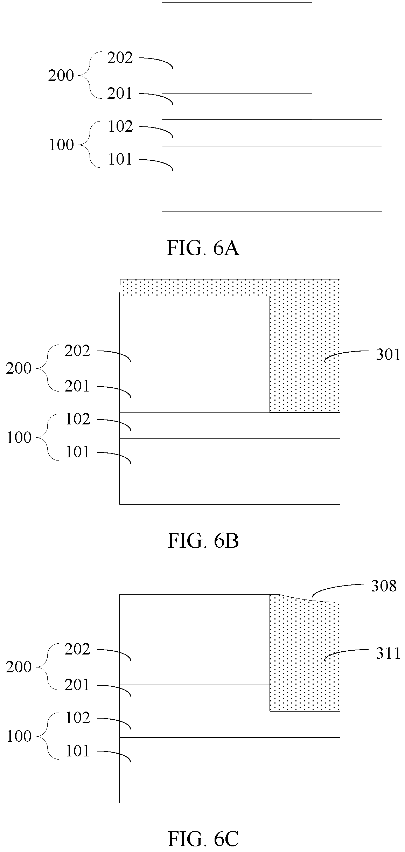

Refer to FIG. 6A to FIG. 6I (a partially enlarged view of a corresponding area in a dashed-line box P2 in FIG. 4). FIG. 6A to FIG. 6I are diagrams of a process of forming the redistribution layer 400 and the first filling layer 312.

FIG. 6A shows that the first chip 200 is stacked on the substrate 100. After the first chip 200 is bonded with the substrate 100, the filling material 301 may be filled around the first chip 200 to form the first filling part 311.

FIG. 6B shows that the filling material 301 is filled around the first chip 200. To ensure a packaging effect, after filling, an upper surface of the filling material 301 is higher than an upper surface of the first chip 200. This is not conducive to forming the redistribution layer 400 on the upper surface of the first chip 200.

FIG. 6C shows that planarization processing is performed on the upper surface of the first chip 200 and/or the upper surface of the filling material 301. After filling around the first chip 200, planarization processing needs to be performed on the upper surfaces of the filling material 301 and the first chip 200. However, due to a difference between a material of the upper surface of the filling material 301 and a material of the upper surface of the first chip 200, a bowl-shaped defect 308 may be caused on the upper surface of the filling material 301 during planarization processing.

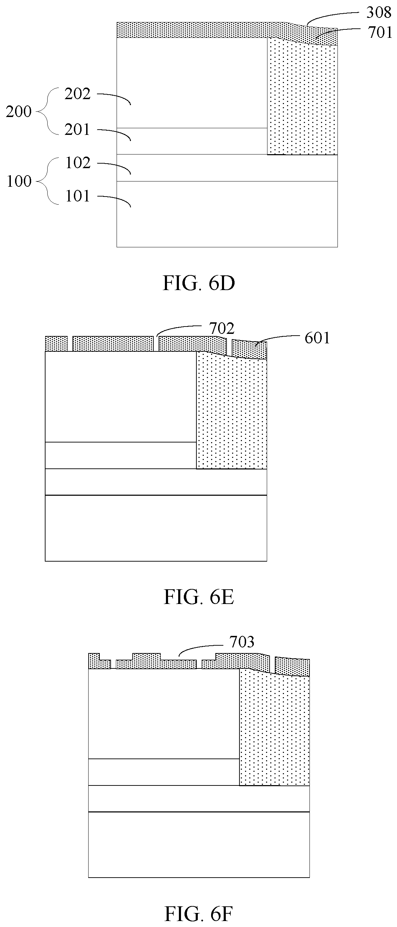

As shown in FIG. 6D, after planarization processing, the redistribution layer 400 is formed on the upper surface of the first chip 200 to stack the second chip 500. When the redistribution layer 400 is formed, an insulating dielectric material 701, for example, silicon dioxide, is simultaneously deposited on the upper surface that is formed by performing planarization on the first chip 200 and the first filling part 311, to form the dielectric layer 401 and the first filling layer 312. In other words, the dielectric layer 401 and the first filling layer 312 are disposed at a same layer. It should be noted that the dielectric layer 401 and the first filling layer 312 are distinguished based on different positions of the dielectric layer 401 and the first filling layer 312. The dielectric layer 401 is located right above the first chip 200, and the first filling layer 312 is located right above the first filling part 311. Because the bowl-shaped defect 308 may be caused on the upper surface of the first filling part 311 after planarization, after the insulating dielectric material 701 is deposited on the first filling part 311, a bowl-shaped defect 308 may also be caused at a position that is on the insulating dielectric material 701 and that corresponds to a position of the bowl-shaped defect 308 on the first filling part 311.

The inventor of this application finds through research that, a main reason that the bowl-shaped defect 308 is caused is that the deposition process is usually uniform deposition. However, because the insulating dielectric material 701 is deposited, the insulating dielectric material 701 may alleviate the bowl-shaped defect 308. To be specific, because a thickness of the deposited insulating dielectric material 701 is uniform, a maximum depth of the bowl-shaped defect 308 does not change. However, the insulating dielectric material 701 causes a transition portion from an edge of a flat region to an edge of a bowl-shaped region to be less steep. This is similar to that deposition on a right-angled surface and may transform a deposited surface into a circular arc surface. Therefore, within a specific error range, a diameter of the bowl-shaped defect 308 may be considered to become small. The diameter may be a maximum size of the opening perpendicular to the depth direction of the bowl-shaped defect 308.

As shown in FIG. 6E to FIG. 6F, steps of forming the dielectric layer 401 further include forming a pattern of the wiring layer 402 by using a process such as exposure, development, etching, or the like. FIG. 6E shows that a contact hole or a through via 702 for electrically connecting the wiring layer 402 to the first chip 200, and an annular groove 601 that is in the first filling layer 312 and in which the support ring 600 is embedded are formed. FIG. 6F shows that a wiring groove 703 for the conductive wire in the wiring layer 402 is formed.

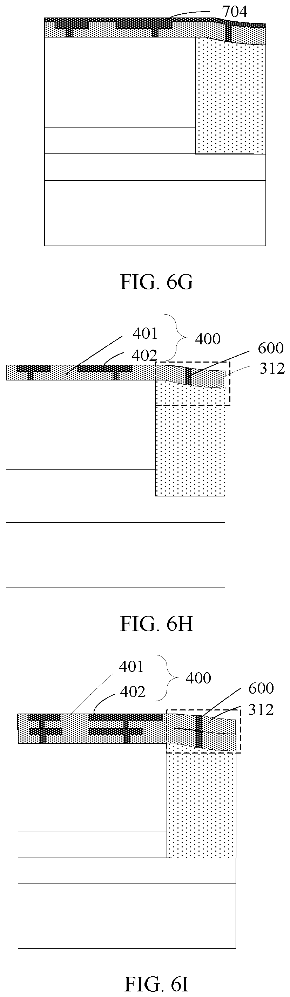

As shown in FIG. 6G, to form the wiring layer 402 and the support ring 600, a conductive material 704, for example, copper, is deposited on the patterns formed on the wiring layer 402 and the first filling layer 312. In some processes, to ensure that the conductive material is uniformly applied to a preset surface, before depositing the conductive material 704, a seed layer is further formed on the preset surface through sputtering.

As shown in FIG. 6H, to remove a redundant conductive material 704, planarization processing, such as chemical physical polishing, may be performed subsequently. Before planarization processing is performed, because the support ring 600 is embedded in a position of the bowl-shaped defect 308, overall wear resistance performance of a region of the bowl-shaped defect 308 is changed. In this way, the region of the bowl-shaped defect 308 is close to the region in which the wiring layer 402 is located, thereby avoiding aggregating the bowl-shaped defect on the insulating dielectric material 701 due to poor wear resistance of the first filling layer 312. In addition, because the bowl-shaped defect 308 is reduced when the insulating dielectric material 701 is deposited, after the support ring 600 is disposed in the bowl-shaped defect 308, the support ring 600 provides support to protect a less steep bowl-shaped region that is at a periphery of the support ring 600 during planarization processing. In this way, a problem of formation of the void 306 in the second filling part caused by the defect may be alleviated or avoided.

The redistribution layer 400 may include a plurality of dielectric layers 401 and a plurality of wiring layers 402. The plurality of dielectric layers 401 and the plurality of wiring layers 402 may be formed by performing the processes shown in FIG. 6B to FIG. 6F for a plurality of times, and the support ring 600 is disposed in each operation.

The following describes, by using several specific examples, the semiconductor package structure 1 provided in this embodiment of this application.

### Example 1

Return to FIG. 3. The semiconductor package structure 1 includes the substrate 100 and the filling part 310. The substrate 100 includes the substrate body 101 and the substrate interconnection layer 102, and the filling part 310 includes the first filling part 311, the first filling layer 312, and the second filling part 313.

The upper surface of the substrate 100 is in close contact with the lower surface of the filling part 310. In other words, the upper surface of the substrate 100 is in close contact with the lower surface of the first filling part 311.

The first filling layer 312 is disposed between the first filling part 311 and the second filling part 313. Therefore, the filling part 310 is continuous in the direction perpendicular to the surface of the substrate. A region for packaging a to-be-packaged component is formed inside the filling part 310.

FIG. 4 is a sectional view in the A-A' direction in FIG. 3. The first chip 200, the redistribution layer 400, and the second chip 500 are stacked on the upper surface of the substrate 100. The first chip 200 includes the first interconnection layer 202 and the first chip body 201, and the second chip includes the second interconnection layer 502 and the second chip body 501. The first chip 200 is bonded with the substrate interconnection layer 102 through the first interconnection layer 202, to form the redistribution layer 400 on the first chip 200. The redistribution layer 400 is electrically connected to the first chip through the conductive wire in the through via that runs through the first chip body 201. The second chip 500 is bonded with the redistribution layer 400 through the second interconnection layer 502. It may be understood that a redistribution layer and a chip may be further sequentially stacked on the second chip 500, to achieve a higher integration level.

The first filling part 311 is disposed around the side face of the first chip 200. The first filling layer 312 is disposed around a side face of the redistribution layer 400. The second filling part 313 is disposed to surround the side face of the second chip 500, and the second filling part 313 covers the upper surface of the second chip 500.

Refer to FIG. 5. The support ring 600 is embedded in the first filling layer 312, a plane on which a surface that is of the second chip 500 and that is close to the first chip 200 is located is used as the first reference plane, and the support ring 600 is located on the side that is of the first reference plane and that is close to the substrate 100. In this case, the upper surface of the support ring 600 is not higher than a lower surface of the second chip 500, thereby avoiding causing an adverse effect when the second filling part 313 is disposed.

In some implementations, in the direction perpendicular to the substrate, the support ring 600 runs through the first filling layer 312. In other words, a lower surface of the support ring 600 is in contact with the first filling part 311, and the upper surface of the support ring 600 is in contact with the second filling part 313.

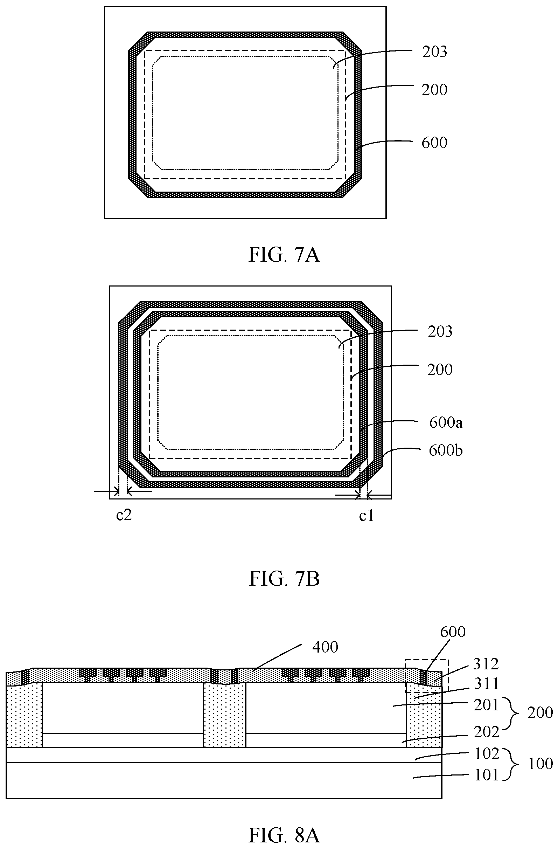

Still refer to FIG. 7A. FIG. 7A is a sectional view in a B-B' direction in FIG. 3. The orthographic projection of the support ring 600 on the substrate 100 is disposed to surround the orthographic projection of the first chip 200, and the orthographic projection of the support ring 600 is spaced apart from the orthographic projection of the first chip 200. In some embodiments, a sealing ring 203 is disposed in the first chip 200, and a shape of the support ring 600 is the same as a shape of the sealing ring 203. To be specific, the support ring 600 is in a shape of the sealing ring 203 scaled up proportionally. For example, a distance from any point on an inner side of the orthographic projection of the support ring 600 on the substrate 100 to the orthographic projection of the sealing ring 203 on the substrate 100 stays equal.

For the packaging method of the semiconductor package structure 1 in this embodiment, in some embodiments, the first chip 200 is placed on the substrate 100, and the first chip 200 is bonded with the substrate 100. The filling material 301 is filled around the first chip 200, and planarization processing is performed on the upper surfaces of the filling material 301 and the first chip 200.

After planarization processing, as shown in FIG. 8A, the redistribution layer 400, the first filling layer 312, and the support ring 600 are disposed.

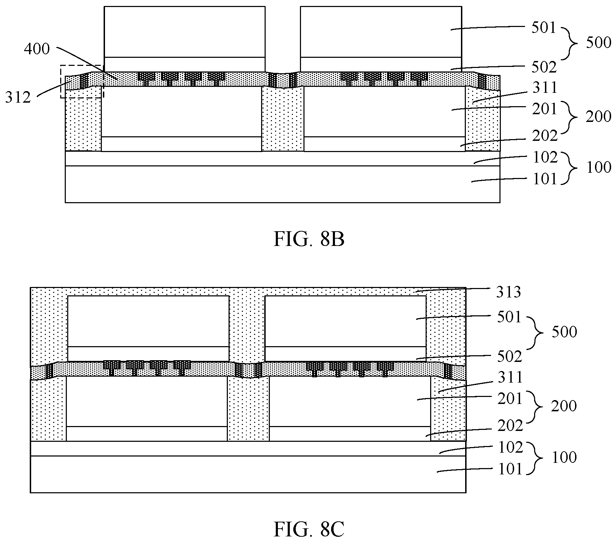

As shown in FIG. 8B, the second chip 500 is stacked on the redistribution layer 400.

As shown in FIG. 8C, the filling material 301 is used to further fill around the second chip 500, and the filling material 301 is also located on the first filling layer 312 to form the second filling part 313. In this way, main steps of preparing the semiconductor package structure 1 are completed.

Because the support ring 600 is disposed in the first filling layer 312, when planarization processing is performed after the sputtering process is completed, wear resistance of a region in which the first filling layer 312 is located is improved, thereby helping alleviate or avoid the bowl-shaped defect.

### Example 2

A difference between Example 2 and Example 1 lies in a process of forming the redistribution layer 400, the first filling layer 312, and the support ring 600.

Still refer to FIG. 5. The redistribution layer 400 includes the dielectric layer 401 and the wiring layer 402, the first filling layer 312 and the dielectric layer 401 are disposed at a same layer, and the wiring layer 402 and the support ring 600 are disposed at a same layer. It should be emphasized that disposing at a same layer does not limit a position in a height direction, but means using a same process for simultaneous forming. Therefore, the first filling layer 312 and the dielectric layer 401 are made of a same material.

To be specific, the insulating dielectric material 701 is deposited on the upper surface on which planarization processing is performed, and a photolithography process is performed on the insulating dielectric material 701 to form, in a region right above the first chip, the dielectric layer 401, and the contact hole or the through via 702 and the wiring groove 703 that are used to form the wiring layer 402; and form, in a region right above the first filling part 311, the first filling layer 312 and the annular groove 601 for accommodating the support ring 600. In this way, the dielectric layer 401 and the first filling layer 312 are disposed at a same layer. Deposition at a same layer avoids additional process steps and reduces costs.

Then, a conductive material is disposed, by using a sputtering process, in the contact hole or the through via 702, the wiring groove 703, and the annular groove 601 for accommodating the support ring 600, and planarization processing is performed again. In this way, the wiring layer 402 and the support ring 600 are formed by disposing the wiring layer 402 and the support ring 600 at a same layer. For a complex redistribution layer 400, a photolithography process, a sputtering process, and planarization processing may be performed for a plurality of times to form the plurality of dielectric layers 401, the plurality of wiring layers 402, a plurality of the first filling layers 312, and a plurality of the support rings 600. It is easy to understand that the support ring 600 is embedded in the first filling layer 312 after planarization processing. In the foregoing preparation process, because the conductive material is disposed in the contact hole or the through via 702, the wiring groove 703, and the annular groove 601 for accommodating the support ring 600 by using the same sputtering process, the support ring 600 and the wiring layer 402 are made of a same material.

### Example 3

A difference between Example 3 and Example 1 and Example 2 lies in a time in which the redistribution layer 400 is disposed. In this example, the redistribution layer 400 may be formed on the first chip 200 before the first chip 200 is attached to the substrate. For example, the redistribution layer 400 may be formed on the first chip body 201 of the first chip 200 by using a front-end process, or the redistribution layer may be formed on the first chip 200 by using an RDL (Redistribution Layer) process after the front-end process is completed and the substrate is diced to form the first chip 200.

After the first chip 200 is attached to the substrate 100, and the filling material 301 is used to fill around the first chip 200, the support ring 600 is disposed on an upper portion of the first filling part 311 formed by the filling material 301. The disposing manner may also be using photolithography followed by sputtering.

To prevent the filling material from blocking the bonding contact on the redistribution layer 400 and facilitate stacking of the second chip 500, planarization processing also needs to be performed on the redistribution layer 400 and the filling material 301. Similarly, during planarization processing, the support ring 600 is disposed on the upper portion of the first filling part 311, so that wear resistance of the region in which the first filling layer 312 is located is improved. This helps alleviate or avoid a concave region.

It can be learned that, in this example, for a specific difference between the filling material 301 and the support ring 600, a material of the support ring 600 may be selected, so that wear resistance of a surface jointly formed by the support ring 600 and the filling material 301 is consistent with wear resistance of the redistribution layer 400 on the first chip 200, and the bowl-shaped defect 308 is avoided as much as possible.

After planarization, the second chip 500 is stacked on the redistribution layer 400, and then the filling material may be directly filled around the second chip 500 to form the second filling part 313. As a result, the first filling part 311 and the second filling part 313 are disposed in close contact with each other. In other words, the first filling part 311 and the second filling part 313 are continuous in the direction perpendicular to the substrate 100. In this case, the filling part 310 includes only the first filling part 311 and the second filling part 313.

### Example 4

A difference between Example 4 and Example 1 to Example 3 lies in a quantity of support rings 600, and there are a plurality of support rings 600 in Example 3. In this example, two support rings 600 are used for description.

In some implementations, FIG. 7B is another sectional view in the B-B' direction in FIG. 3. As shown in FIG. 7B, the support rings 600 include a support ring 600a and a second support ring 600b.

The plurality of support rings 600 are radially arranged from inside to outside. To be specific, a size of the support ring 600a is less than a size of the second support ring 600b, the support ring 600a is disposed inside the second support ring 600b, and an outer side wall of the support ring 600a is disposed at a specific distance from an inner side wall of the second support ring 600b.

In this example, the plurality of support rings 600 are disposed, so that during planarization processing, wear resistance of a region in which the first filling layer 312 or the first filling part 311 is located can be improved, and the wear resistance of the region does not change greatly in the region, thereby improving uniformity of the wear resistance in the region, and helping further alleviate or avoid a concave region.

In some embodiments, a cross section of the second support ring 600b has a width c2 in a direction parallel to the substrate 100, and a cross section of the support ring 600a has a width c1 in the direction parallel to the substrate 100, where c2 is greater than c1. For the singulated semiconductor package structure 1, in the direction parallel to the substrate 100, the bowl-shaped defect exhibits a greater degree of depression at a place farther away from an edge of the first chip 200. Therefore, a larger width of the support ring 600 farther away from the edge of the first chip 200 can increase wear resistance of a region in which the support ring 600 is located, and can better compensate the bowl-shaped depression.

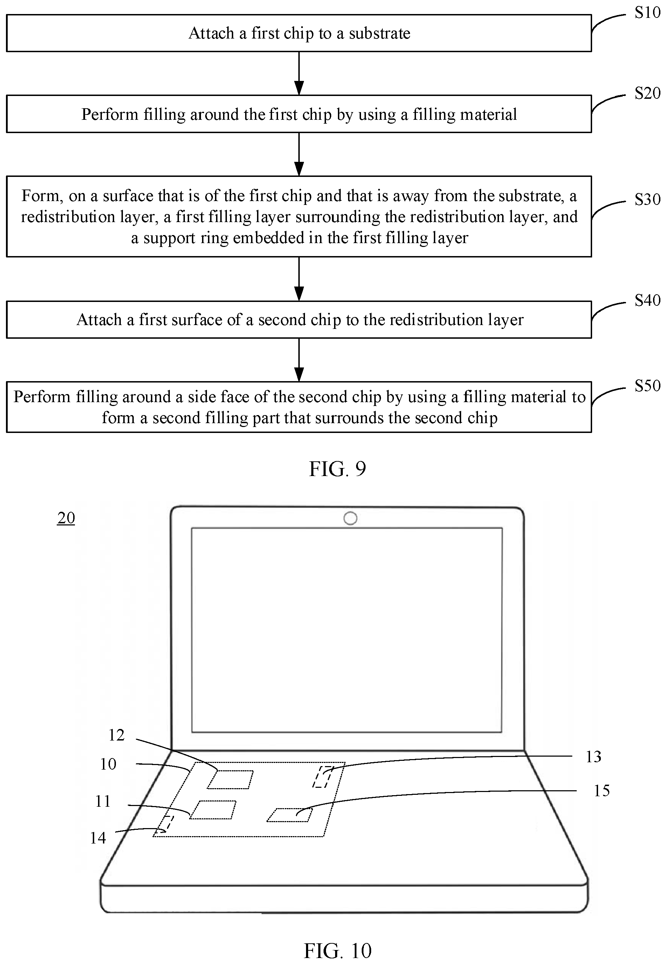

An embodiment of this application further provides a packaging method of a semiconductor package structure 1. As shown in FIG. 9, the packaging method of the semiconductor package structure 1 includes S10 to S50.

S10: As shown in FIG. 1A, attach the first chip 200 to the substrate 100.

In some implementation, the substrate 100 includes a substrate body 101 and a substrate interconnection layer 102, and a bonding contact is disposed on the substrate interconnection layer 102. The first chip 200 includes a first chip body 201 and a first interconnection layer 202, and a bonding contact is also disposed on the first interconnection layer 202. The first interconnection layer 202 is placed on the substrate interconnection layer 102, so that the bonding contacts of the first interconnection layer 202 and the substrate interconnection layer 102 are in a one-to-one correspondence for bonding.

For example, as shown in FIG. 2A, a plurality of first chips 200 may be attached to a same substrate 100, and a gap between the plurality of chips may be used as a dicing street, to perform a singulation operation after subsequent packaging is completed. In some implementation, one first chip 200 may be separately attached to the substrate 100, and a surface of the substrate 100 is covered after a filling material is filled around the first chip 200. Therefore, after the semiconductor package structure 1 is formed through stacked packaging, a singulation operation may not be performed. However, to remove a defect on a surface of the semiconductor package structure 1 such as a burr, the surface of the formed semiconductor package structure 1 may be polished.

Herein, bonding may be eutectic bonding, metal thermocompression bonding, hybrid bonding, or the like.

S20: As shown in FIG. 2B, use the filling material 301 to perform filling around the first chip 200.

After the filling material 301 is filled around the first chip 200, a bottom of the filling material 301 is in contact with the substrate 100, and the filling material 301 fills the gap between the plurality of first chips 200, and is in contact with the first chip 200 from a side face to surround the side face of the first chip 200. For example, in a direction perpendicular to the substrate 100, a height of the filling material 301 may be flush with an upper surface of the first chip 200.

The height of the filling material 301 may be higher than the upper surface of the first chip 200, or even covers the upper surface of the first chip 200. Therefore, planarization processing further needs to be performed, so that the upper surface of the first chip 200 is exposed. Planarization processing may be performed by using chemical mechanical polishing, etching, or another suitable process.

In this case, the filling material 301 includes only a portion surrounding a side edge of the first chip, to form the first filling part 311. It is expected that, after planarization processing, the upper portion of the first chip 200 is flush with an upper surface of the first filling part 311, and both are on a same plane. However, because the filling material 301 and the upper surface of the first chip 200 have different performance such as wear resistance or corrosion resistance, a bowl-shaped depression 308 is formed on the upper surface that is of the first filling part 311 and that is formed by performing planarization processing on the filling material 301, as shown in FIG. 6C. The bowl-shaped depression 308 may cause adverse impact on packaging, and needs to be avoided as much as possible.

S30: As shown in FIG. 6D to FIG. 6G, form, on a surface that is of the first chip 200 and that is away from the substrate 100, the redistribution layer 400, the first filling layer 312 surrounding the redistribution layer 400, and the support ring 600 embedded in the first filling layer 312.

To be specific, as shown in FIG. 6D, the insulating dielectric material 701 is deposited on a surface jointly formed by the first chip 200 and the first filling part 311. The insulating dielectric material 701 is usually silicon nitride, silicon dioxide, or the like. The insulating dielectric material 701 is usually deposited by using chemical vapor deposition (chemical vapor deposition, CVD). It may be considered that the insulating dielectric material 701 is uniformly deposited on the upper surfaces of the first chip 200 and the first filling part 311. Because the insulating dielectric material 701 is deposited, the insulating dielectric material 701 may alleviate the bowl-shaped defect 308.

As shown in FIG. 6E to FIG. 6F, a photolithography process is performed on the insulating dielectric material 701, to form, above the first chip 200, the dielectric layer 401 on which a contact hole or a through via 702 and the wiring groove 703 are provided, and form, above the first filling part 311, the first filling layer 312 on which the support ring 600 is disposed. It may be understood that the dielectric layer 401 and the first filling layer 312 are simultaneously formed by using a same process, that is, disposed at a same layer. The dielectric layer 401 and the first filling layer 312 are distinguished based on positions of the dielectric layer 401 and the first filling layer 312.

As shown in FIG. 6G to FIG. 6H, the conductive material 704 is deposited in the contact hole or the through via 702, the wiring groove 703, and the annular groove 601 that are formed by using processes such as photolithography or etching, to form the wiring layer 402 of the redistribution layer 400 and the support ring 600. The conductive material 704 is usually deposited by using physical vapor deposition (physical vapor deposition, PVD), or may be deposited by using CVD. The conductive material 704 is usually copper. Before the conductive material 704 is deposited, an isolation layer and a seed layer further need to be disposed on a surface, to prevent the conductive material from diffusing into the insulating dielectric material and affecting insulation.

Similarly, to ensure conductivity of the wiring layer 402, when the conductive material 704 is deposited, it needs to be ensured that the contact hole or the through via 702, the wiring groove 703, and the annular groove 601 are fully filled. Therefore, the conductive material 704 overflows from the contact hole or the through via 702, the wiring groove 703, and the annular groove 601, and planarization processing needs to be performed to remove the overflowed conductive material 704. In this way, the conductive material 704 above the first chip 200 forms the wiring layer 402, and the conductive material 704 above the first filling part 311 forms the support ring 600.

Because the support ring 600 formed by the conductive material is added to the first filling layer 312, wear resistance or corrosion resistance of the region in which the first filling layer 312 is located is improved, and the support ring 600 provides support. Therefore, when the conductive material 704 is removed through planarization, a planarization rate of the region in which the first filling layer 312 is located is reduced, thereby alleviating the bowl-shaped depression in the region.

In some implementations, the redistribution layer 400 includes a plurality of dielectric layers 401 and a plurality of wiring layers 402. In this case, the first filling layer 312 also has a plurality of layers. Layers on which the support rings 600 are formed may be selected based on the degree of the bowl-shaped defect. Refer to FIG. 6I. For example, there are two dielectric layers 401 and two wiring layers 402, but the support ring 600 exists only on one layer away from the first chip 200. An implementation method is that when the process such as photolithography or etching is performed on a layer close to the first chip 200, the annular groove 601 in which the support ring 600 that corresponds to the layer is disposed is not formed in the insulating dielectric material. Therefore, when the conductive material 704 is deposited, the portion of the support ring 600 corresponding to the layer is not formed in the annular groove 601. Therefore, in some implementations, the support ring 600 may be located on a side of a plane on which the surface of the first chip 200 is close to the second chip 500, that is, a disposing position of the support ring 600 is not lower than the upper surface of the first chip 200. In other words, in this case, the support ring 600 is located between the first chip 200 and the second chip 500.

It may be understood that, to implement an electrical connection between the redistribution layer 400 and the second chip 500, a bonding contact is further disposed on the redistribution layer 400.

In this way, the formed support ring 600 is located on a periphery of the redistribution layer 400, the first filling layer 312 is in contact with the first filling part 311, and an orthographic projection of the support ring 600 on the substrate 100 surrounds an orthographic projection of the first chip 200 on the substrate 100.

S40: As shown in FIG. 8B, attach a first surface of the second chip 500 to the redistribution layer 400.

Attaching the first surface of the second chip 500 to the redistribution layer 400 is similar to attaching the first chip 200 to the substrate 100. Details are not described herein again.

However, because the second chip 500 is attached to the redistribution layer 400 after planarization processing is performed on the redistribution layer 400 and the first filling layer 312, it can be learned that if a plane on which a lower surface of the second chip 500 is located is used as a first reference plane, the support ring 600 is located on a side that is of the first reference plane and that is close to the substrate 100.

S50: As shown in FIG. 8C, use the filling material 301 to perform filling around the side face of the second chip 500, to form the second filling part 313 surrounding the second chip 500.

After filling, a lower surface of the filling material 301 is in contact with the redistribution layer 400, and surrounds the side face of the second chip 500. It may be understood that, when only two chips are stacked, the filling material 301 may cover an upper surface of the second chip 500, and isolate the semiconductor package structure 1 from an external environment, to provide a stable environment for the first chip 200 and the second chip 500 inside the semiconductor package structure 1, and improve a service life of the semiconductor package structure 1.

In addition, because the support ring 600 is disposed when the redistribution layer 400 and the first filling layer 312 are formed, the bowl-shaped defect on the first filling layer 312 is alleviated. This avoids formation of the void 306 in the second filling part 313, and improves stability of the semiconductor package structure 1. In some implementations, the plurality of first chips 200 and the plurality of second chips 500 are correspondingly stacked on one substrate 100. Because the support ring 600 is disposed on the periphery of the redistribution layer 400, integrity of the redistribution layer 400 can be ensured when the semiconductor packaging junction 1 is singulated, thereby improving a yield rate.

This application further provides an electronic device 20. The electronic device is a type of electronic device with functions such as data storage and/or program running, and the electronic device includes any one of the foregoing semiconductor package structures 1. To be specific, the electronic device includes but is not limited to a mobile phone, a tablet computer (tablet computer), a laptop computer (laptop computer), a personal digital assistant (personal digital assistant, PDA), a personal computer, a notebook computer, a vehicle-mounted device, a wearable device, and the like. The wearable device includes but is not limited to a smart band, a smartwatch, a smart head-mounted display, smart glasses, and the like.

This application is described by using an example in which the electronic device 20 is a notebook computer. FIG. 10 is a diagram of a structure of the notebook computer. A core component of the notebook computer includes a computer main board 10, and the computer main board is responsible for connecting various hardware devices and providing functions such as a power supply and data transmission. There are many different components on the main board, including a processor chip 11, a memory chip 12, a power socket 13, a USB interface 14, an IDE serial port 15, and the like. The computer main board is a printed circuit board (printed circuit board, PCB). A main function of the main board is to transmit an electrical signal between components on the main board, and electrical signals of various chips are transmitted very frequently, especially the processor chip 11. Based on functions, the chip may include a processor chip, a storage chip, a power supply chip, and the like. A manner of attaching the chip on the main board varies based on a specific application scenario. For example, to improve scalability of the notebook computer, the chip may be attached to the main board through a socket; and to ensure a high-quality electrical connection, the chip may be attached to the main board through soldering. For example, the processor chip 11 is usually mounted on the main board 10 through soldering, and the memory chip is mounted on the main board 10 through a socket.

In some implementations, the semiconductor package structure 1 may be the memory chip 12 of the notebook computer. A plurality of individual memory chips are packaged in a stacked manner in the memory chip 12. The memory chip 12 is mounted on the computer main board, and is connected to a power supply, an input/output device, and the like through the printed circuit board.

In some other implementations, the semiconductor package structure 1 may include a processor chip and a storage chip. The processor chip and the storage chip are packaged in a stacked manner to form the semiconductor package structure 1, and then the semiconductor package structure 1 is mounted on the computer main board, and is electrically connected to other components on the computer main board.

The descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A semiconductor package structure, comprising:
a substrate, and a first chip and a second chip that are stacked on the substrate, wherein the first chip is located between the substrate and the second chip;
a filling part, surrounding a side face of the first chip and a side face of the second chip, and being continuous in a direction perpendicular to the substrate; and
a support ring, wherein an orthographic projection of the support ring on the substrate surrounds an orthographic projection of the first chip on the substrate, the support ring is embedded in the filling part, and is located on a side that is of a first reference plane and that is close to the substrate, and the first reference plane is a plane on which a surface that is of the second chip and that is close to the first chip is located.

2. The semiconductor package structure according to claim 1, wherein the support ring is located between the first reference plane and a second reference plane, and the second reference plane is a plane on which a surface that is of the first chip and that is close to the second chip is located.

3. The semiconductor package structure according to any one of claims 1 to 2, wherein a redistribution layer is disposed on a surface that is of the first chip and that is away from the substrate, the redistribution layer comprises a dielectric layer, the filling part comprises a first filling layer, the first filling layer surrounds at least a portion of a region between the first chip and the second chip, a material of the first filling layer is the same as a material of the dielectric layer, and the support ring is embedded in the first filling layer.

4. The semiconductor package structure according to claim 3, wherein the first filling layer and the dielectric layer are disposed at a same layer.

5. The semiconductor package structure according to claim 3, wherein the redistribution layer further comprises a plurality of wiring layers, the plurality of wiring layers are stacked in the direction perpendicular to the substrate, the wiring layers are embedded in the dielectric layer, and a material of the support ring is the same as a material of the wiring layer.

6. The semiconductor package structure according to claim 5, wherein the support ring and at least one wiring layer that is farthest away from the substrate are disposed at a same layer.

7. The semiconductor package structure according to claim 5, wherein a surface that is of the support ring and that is away from the substrate is flush with a surface that is of a wiring layer farthest away from the substrate and that is away from the substrate.

8. The semiconductor package structure according to claim 3, wherein the support ring runs through the first filling layer in the direction perpendicular to the substrate.

9. The semiconductor package structure according to any one of claims 3 to 8, wherein the filling part further comprises a first filling part, the first filling part is located between the first filling layer and the substrate, the first filling part surrounds the side face of the first chip, and the material of the first filling layer is different from a material of the first filling part.

10. The semiconductor package structure according to claim 9, wherein the filling part further comprises a second filling part disposed on a side that is of the first filling layer and that is away from the substrate, the second filling part surrounds the side face of the second chip, and the material of the first filling layer is different from a material of the second filling part.

11. The semiconductor package structure according to any one of claims 1 to 10, wherein there are a plurality of support rings that are radially arranged from inside to outside in a direction parallel to the substrate.

12. The semiconductor package structure according to claim **11,** wherein among adjacently disposed support rings, a width of a support ring located on an inner side is greater than a width of a support ring located on an outer side, and the width is a size in the direction parallel to the substrate.

13. A packaging method of a semiconductor package structure, comprising:
attaching a first chip to a substrate;
performing filling around the first chip by using a filling material to form a first filling part that surrounds a side face of the first chip;
forming, on a surface that is of the first chip and that is away from the substrate, a redistribution layer, a first filling layer surrounding the redistribution layer, and a support ring located in the first filling layer, wherein the first filling layer is in contact with the first filling part, and an orthographic projection of the support ring on the substrate surrounds an orthographic projection of the first chip on the substrate;
attaching a second chip to the redistribution layer; and
performing filling around a side face of the second chip by using a filling material, to form a second filling part surrounding the second chip, wherein the second filling part is in contact with the first filling layer.

14. The method according to claim 13, wherein the redistribution layer comprises a dielectric layer and a wiring layer, and the first filling layer and the dielectric layer are simultaneously formed.

15. The method according to claim 14, wherein the support ring and at least a portion of the wiring layer are simultaneously formed.

16. An electronic device, comprising the semiconductor package structure according to any one of claims 1 to 12 and a printed circuit board, wherein the semiconductor package structure is attached to the printed circuit board.
